# EUROPÄISCHE PATENTSCHRIFT

(11) **EP 1 117 851 B1**
(45) Veröffentlichungstag und Bekanntmachung des Hinweises auf die Patenterteilung: **05.06.2002**
(21) Anmeldenummer: 99953526.3
(22) Anmeldetag: 13.08.1999
(51) Int. Cl.: C23C 14/08, G02F 1/15, C09K 9/00

(54) **VERFAHREN ZUM HERSTELLEN EINER ELEKTROCHROMEN SCHICHT**
METHOD FOR PRODUCING AN ELECTROCHROMIC LAYER
PROCEDE POUR PRODUIRE UNE COUCHE ELECTROCHROME

(30) Priorität: 28.08.1998 DE 19839299
(43) Veröffentlichungstag der Anmeldung: 25.07.2001
(73) Patentinhaber: Pilkington Deutschland AG, 45884 Gelsenkirchen (DE)
(72) Erfinder: NÖTHE, Axel, D-44575 Castrop-Rauxel (DE); MENZEL, Stefan, D-93437 Furth im Wald (DE)
(74) Vertreter: Tönhardt, Marion, Dr.
(86) Internationale Anmeldenummer: DE9902582
(87) Internationale Veröffentlichungsnummer: WO0012774

(56) Entgegenhaltungen:
- WO-A-96/06203
- DE-A- 4 305 414

## Beschreibung

Die Erfindung bezieht sich auf ein Verfahren zum Herstellen einer elektrochromen Schicht auf einem Substrat durch Kathodenzerstäubung eines Targets in einer Wasserstoffionen enthaltenden Beschichtungsatmosphäre sowie auf ein elektrochromes Element mit mindestens einer solchen Schicht.

Als elektrochrome Schichten werden Schichten bezeichnet, die reversibel Kationen, insb. H⁺-lonen oder Li⁺-Ionen, aufnehmen (interkalieren) und wieder abgeben (dekalieren) können, wobei sich ihre optischen Eigenschaften in der Regel ändern. Sie bestehen meist aus Metalloxiden oder Metallmischoxiden. Elektrochrome Materialien umfassen anodisch und kathodisch einfärbbare Materialien wie auch reine lonenspeicher-Materialien, deren optische Eigenschaften nur wenig oder gar nicht von der Menge der interkalierten Kationen abhängen.

Elektrochrome Elemente finden zunehmendes Interesse als sogenannte intelligente Fenster, deren Lichttransmission oder andere optische Eigenschaften durch das zeitweise Anlegen einer elektrischen Spannung gezielt beeinflußt werden können. Derartige elektrochrome Elemente bestehen in der Regel aus einseitig mit Leitschichten versehenen Substraten, insbesondere aus transparentem Glas oder Kunststoff, wobei auf den Leitschichten jeweils eine elektrochrome Schicht angeordnet ist. Die so beschichteten Substrate werden unter Zwischenschaltung eines Elektrolyten (Ionenleiters) miteinander verbunden. Durch Anlegen einer Spannung an die Leitschichten werden im elektrochromen Element befindliche Kationen, in der Regel H⁺- oder Li⁺-Ionen, in eine der elektrochromen Schichten (die elektrochrome Schicht im eigentlichen Sinne) interkaliert, wodurch sich deren optische Eigenschaften im gewünschten Sinne ändern. Die andere elektrochrome Schicht, die meist aus einem anderen Material als die erstgenannte elektrochrome Schicht besteht, dient häufig als ihre optischen Eigenschaften nicht nennenswert ändernde Ionenspeicherschicht, die beim Anlegen einer Spannung mit umgekehrtem Vorzeichen die nunmehr aus der anderen elektrochromen Schicht dekalierten Kationen aufzunehmen in der Lage ist.

Ein derartiges elektrochromes Element ist beispielsweise den Veröffentlichungen DE 197 06 918 A1, EP 0 683 215 A1, WO 95 / 31 746 A1 zu entnehmen. Als Material fiir die elektrochrome Schicht im eigentlichen Sinne, die ihre optischen Eigenschaften beim Interkalieren und Dekalieren von Kationen deutlich ändert, hat sich in der Praxis vor allem Wolframoxid (WOₓ), als Mischoxid oder mit Dotierungszusätzen durchgesetzt. Als Material für elektrochrome Schichten, die als Ionenspeicherschichten verwendet werden, sind u.a. Mischoxide wie Cer-Titan-Oxid oder Vanadium-Titan-Oxid bekannt.

Zur Herstellung solcher elektrochromer Schichten werden eine Reihe von unterschiedlichen Beschichtungsverfahren eingesetzt, darunter z.B. chemische Verfahren wie CVD oder Sol-Gel-Verfahren sowie physikalische Verfahren wie verschiedene Aufdampfverfahren, Ionenplattieren oder Kathodenzerstäubung. Für großflächige elektrochrome Elemente kommt für die Herstellung der einzelnen Schichten aus wirtschaftlichen Gründen vor allem die Kathodenzerstäubung in Betracht, und dabei insbesondere die reaktive Gleichspannungs- oder Mittelfrequenz-Magnetron-Kathodenzerstäubung von metallischen oder halbleitenden Targets.

Elektrochrome Schichten sind in der Regel nicht unmittelbar nach ihrer Herstellung bzw. nach dem Zusammenbau aller Bestandteile zu einem elektrochromen Element voll funktionsfähig. Sie müssen vielmehr konditioniert werden, was bedeutet, daß die elektrochromen Schichten oder das elektrochrome Element mehrfach zyklisch geladen und entladen werden, bis der angestrebte maximale Transmissionshub erreicht wird. Transmissionshub bedeutet die Transmissionsdifferenz zwischen dem eingefärbten und entfärbten Zustand der elektrochromen Schicht bzw. des elektrochromen Elements. Erst danach ist das elektrochrome Element über einen langen Zeitraum gebrauchsfähig und zwischen definierten Anfangs- und Endzuständen schaltbar. Konditioniert man nach dem Stand der Technik hergestellte elektrochrome Schichten mit Hilfe eines Flüssigelektrolyten wie Propylencarbonat mit darin gelöstem Li-Salz und einer Standard-Gegenelektrode, so stellt man fest, daß beim ersten Lade-/Entladezyklus eine erhebliche Differenz zwischen der interkalierten und der dekalierten Ladungsmenge auftritt. Die hieraus errechenbare sogenannte Blindladung (Einheit: mC/cm²) besteht aus positiven Ladungsträgern, z.B. Ht-Ionen oder Li⁺-Ionen, die nach dem ersten Ladezyklus irreversibel in der elektrochromen Schicht verbleiben und damit die Zahl der für das elektrochrome Element verfügbaren Ladungsträger dauerhaft reduzieren. Dabei wurde beobachtet, daß mit einer zunehmenden positiven Blindladung die Dauer der erforderlichen Konditionierung des elektrochromen Elements drastisch zunimmt. Ein lang andauernder Konditionierungsprozeß verteuert aber die Produktion und ist somit unerwünscht. Nach dem Stand der Technik hergestellte elektrochrome Schichten verfügen außerdem häufig über eine unzureichende Speicherkapazität oder eine zu geringe Einfärbeeffizienz (Verhältnis aus Transmissionshub zu interkalierter Ladung pro Flächeneinheit).

Die WO 96/06203A offenbart die Herstellung elektrochromer Elemente durch Beschichtung mit WO₃, Nb₂O₅, V₂O₅, NiO oder IrO₂ mittels reaktiven Sputterns in einer Atmosphäre aus Sauerstoff und Argon.

Aus der GB 2 086 601 A ist ein Verfahren gemäß dem Oberbegriff von Anspruch 1 bekannt Der Beschichtungsatmosphäre werden gemäß dieser Veröffentlichung Sauerstoff und Wasserstoffdampf zugesetzt, um ausgehend von metallischen Targets elektrochrome Hydroxidschichten herzustellen. Als gegenüber der Kathodenzerstäubung mit einer Wasserdampf enthaltenden Beschichtungsatmosphäre klar bevorzugtes Beschichtungsverfahren wird das reaktive Ionenplattieren unter Wasserdampfzusatz angewendet. Die so hergestellten elektrochromen Schichten werden für die Fertigung von elektrochromen Displays genutzt, bei denen H⁺-Ionen als Ladungsträger zum Einsatz kommen. In einem großtechnischen Sputterprozeß ist der Zusatz von Wasserdampf zur Beschichtungsatmosphäre nur sehr schwierig zu kontrollieren und führt zu großen Ungleichmäßigkeiten in den Schichteigenschaften und in der Schichtdickenverteilung.

Der Erfindung liegt die Aufgabe zugrunde, ein Verfahren bereitzustellen, mit dem durch Kathodenzerstäubung elektrochrome Schichten mit allenfalls geringer positiver oder sogar negativer Blindladung herstellbar sind. Mit dem Verfahren sollen außerdem elektrochrome Schichten mit hoher Speicherkapazität (Aufnahmefähigkeit) für positiv geladene Ionen, insbesondere H⁺-Ionen oder Li⁺-Ionen, herstellbar sein. Dabei soll das Beschichtungsverfahren einfacher zu kontrollieren sein als die Kathodenzerstäubung in einer Beschichtungsatmosphäre mit Wasserdampfzusatz.

Zur Lösung dieser Aufgabe schlägt die Erfindung vor, daß der Beschichtungsatmosphäre mindestens ein gasförmiger Kohlenwasserstoff zugesetzt wird. Besonders geeignet sind dabei die gesättigten Kohlenwasserstoffe, und dabei vor allem Methan. Dieser gasförmige gesättigte Kohlenwasserstoff zeichnet sich durch ein besonders hohes Verhältnis von Wasserstoff zu Kohlenstoff je Molekül aus. Es hat sich gezeigt, daß die angestrebten Wirkungen des erfindungsgemäßen Zusatzes zur Beschichtungsatmosphäre dann am besten erreicht wird, wenn das Verhältnis von Wasserstoff zu Kohlenstoff im Molekül des Kohlenwasserstoffs hoch ist, da bei zu hohem Kohlenstoffgehalt des Moleküls zuviel Kohlenstoff in die Schichten eingebaut wird, wodurch sich die elektrochromen Eigenschaften verschlechtern können. Außerdem kann bei einem hohen H:C-Verhältnis der Gesamtdruck der Beschichtungsatmosphäre vergleichsweise niedrig und damit die Beschichtungsrate relativ hoch eingestellt werden. Andere geeignete Gase sind vor allem Ethan, Propan oder Butan. Es versteht sich, daß der Beschichtungsatmosphäre außerdem stets ein Edelgas, im Normalfall Argon, zugesetzt wird, das als nicht-reaktives Gas zur Targetzerstäubung benötigt wird.

Vor allem bei der im Rahmen der Erfindung besonders bevorzugten reaktiven Kathodenzerstäubung von metallischen oder halbleitenden Targets wird der Beschichtungsatmosphäre außerdem Sauerstoff zugesetzt werden. Dabei wird das Volumenverhältnis von zugesetztem Kohlenwasserstoff zu zugesetztem Sauerstoff bevorzugt im Bereich von 3 : 1 bis 1 : 3, insbesondere etwa 1 : 1. eingestellt. Mit geringeren Mengen an Kohlenwasserstoffen können die angestrebten Wirkungen nicht mehr in ausreichendem Maße erzielt werden, während bei höheren Anteilen von Kohlenwasserstoffen die elektrochromen Eigenschaften der Schichten schlechter werden oder das Sputterverfahren schlechter kontrollierbar wird.

Besonders bevorzugt ist es, wenn bei der reaktiven Kathodenzerstäubung das Volumenverhältnis von Argon zu Sauerstoff im Bereich von 3 : 1 bis 1 : 3, insbesondere etwa 1 : 1. liegt.

Die angegebenen Verhältnisse werden durch entsprechende Einstellungen der Dosierventile für die jeweiligen Gase eingestellt. Ein Verhältnis von 1 : 1 entspricht beispielsweise der gleichen Einstellung der Gasflußrate für beide Gase.

Eine ausreichend hohe Beschichtungsrate sowie besonders gute Schichteigenschaften werden erreicht, wenn mit einem Gesamtdruck der Beschichtungsatmosphäre von 0,3 ^{·} 10⁻² mbar bis 10⁻¹ mbar, insbesondere von 1^{·}10⁻² mbar bis 4^{·}10⁻² mbar, gearbeitet wird.

Das erfindungsgemäße Verfahren eignet sich insbesondere zur Herstellung von elektrochromen Schichten auf Basis von Wolframoxid, wofür dann ein aus Wolfram oder einer Wolframlegierung bestehendes Target eingesetzt wird. Eine andere Anwendung sieht vor, daß ein Molybdän, Titan, Cer, Vanadium und/oder Zirkon enthaltendes Target verwendet wird.

Das Verfahren wird bevorzugt so geführt, daß elektrochrome Schichten in einer Dicke im Bereich von 50 nm bis 500 nm erhalten werden. Dünnere Schichten verfügen im Normalfall nicht mehr über einen ausreichenden Transmissionshub bzw. eine ausreichende Speicherkapazität für Ladungsträger. Dickere Schichten sind bringen keine nennenswerten Vorteile und sind nicht mehr wirtschaftlich in gleichmäßiger Qualität herstellbar.

Mit erfindungsgemäß hergestellten elektrochromen Schichten können elektrochrome Elemente mit hoher Einfärbeeffizienz (hohem Transmissionshub je interkalierter Ladung pro Einheitsfläche) hergestellt werden. In einigen Fällen wurde außerdem eine erhöhte Interkalationsgeschwindigkeit von Ht-Ionen oder Li⁺-Ionen in so hergestellten elektrochromen Schichten beobachtet, so daß elektrochrome Elemente mit höherer Schaltgeschwindigkeit als mit herkömmlich aufgebrachten elektrochromen Schichten hergestellt werden konnten. Vor allem aber kann die zum Konditionieren des elektrochromen Elements benötigte Zeit durch den Einsatz der Erfindung deutlich reduziert werden. Es wurde außerdem festgestellt, daß erfindungsgemäß hergestellte elektrochrome Schichten eine höhere Wärmebeständigkeit im Vergleich zu solchen Schichten zeigen, die ohne erfindungsgemäßen Zusatz zur Beschichtungsatmosphäre hergestellt wurden. Es wird vermutet, daß zumindest ein Teil dieser Effekte auf dem Einbau von Kohlenstoffatomen in die Matrix des elektrochromen Materials beruht. Tatsächlich konnte für erfindungsgemäß hergestellte Schichten durch Thermodesorptionsanalyse festgestellt werden, daß sie Kohlenstoff in der Größenordnung von einigen Atomprozent enthielten. Die Erfindung hat sich besonders bewährt bei der Herstellung von elektrochromen Elementen mit Li⁺-Ionen als Ladungsträgem, und insbesondere mit einem Polymerelektrolyten gemäß WO 95/31 746 A1.

Die Erfindung ist besonders gut anwendbar beim reaktiven DC- oder Mittelfrequenz-Sputtern von metallischen oder halbleitenden Targets in einer Argon, Sauerstoff und Kohlenwasserstoff(e) enthaltenden Beschichtungsatmosphäre. Sie kann jedoch grundsätzlich auch beim HF-Sputtem von oxidischen Targets eingesetzt werden, wobei dann allerdings der Sauerstoffgehalt der Beschichtungsatmosphäre im Normalfall geringer sein wird als bei der reaktiven Kathodenzerstäubung. Erfindungsgemäß hergestellte elektrochrome Schichten werden mit besonderem Vorteil eingesetzt zur Fertigung von hermetisch versiegelten elektrochromen Elementen, bei denen die Anzahl der für den Ladungstransport zur Verfügung stehenden Ladungsträger begrenzt ist. Dabei ist die Erfindung nicht auf elektrochrome Elemente mit Li⁺-Ionen als Ladungsträgern beschränkt. Vielmehr können auch H⁺-Ionen oder andere positiv geladene Ionen verwendet werden.

Die Erfindung wird nachfolgend an Ausführungsbeispielen erläutert.

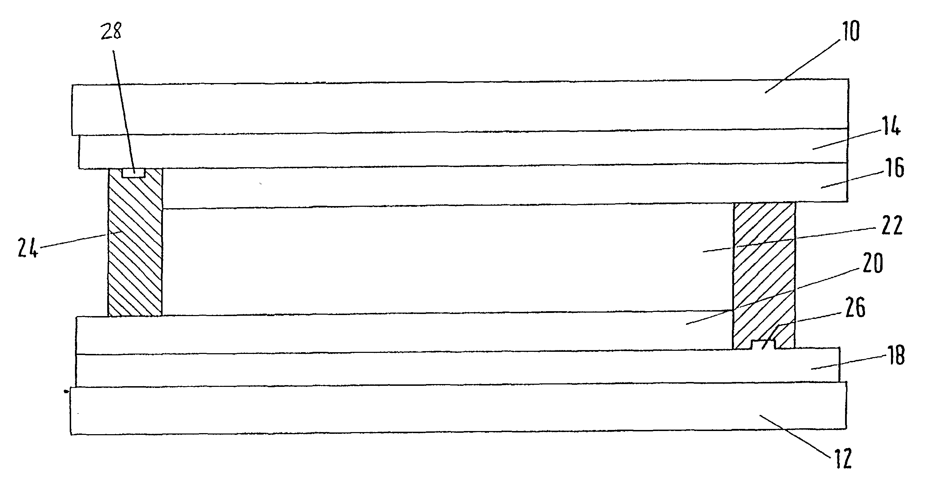

Die einzige Figur zeigt als Prinzipdarstellung ein elektrochromes Element mit einer erfindungsgemäß hergestellten elektrochromen Schicht. Das elektrochrome Element besteht aus einer ersten Glasscheibe 10 und einer zweiten Glasscheibe 12, die beide im wesentlichen eben sind und Abmessungen von beispielsweise etwa 40 · 80 cm² haben. Die erste Glasscheibe 10 trägt an ihrer in der Zeichnung nach unten weisenden Fläche eine erste Leitschicht 14, bei der es sich beispielsweise um eine Indium-Zinnoxid (ITO)-Schicht mit einer Dicke von 300 nm handelt. Auf die erste Leitschicht 14 ist eine elektrochrome Schicht 16 aus WOx nach dem Verfahren gemäß der Erfindung aufgetragen. Die zweite Glasscheibe 12 trägt an ihrer der ersten Glasscheibe 10 zugewandten Seite eine zweite Leitschicht 18, die beispielsweise ebenfalls aus Indium-Zinnoxid besteht, mit einer Dicke von 300 nm. An die zweite Leitschicht 18 schließt sich an der der zweiten Glasscheibe 12 gegenüberliegenden Seite eine lonenspeicherschicht aus CeₓTi_{y}O_{z} mit einer Dicke von 280 nm an, die bevorzugt ebenfalls nach dem erfindungsgemäßen Verfahren hergestellte wurde. Die beiden mit den vorstehend beschriebenen Beschichtungen versehenen Glasscheiben 10, 12 sind nach Art einer Verbundscheibe durch eine Ionenleitschicht 22 miteinander verbunden, welche bei dem gezeigten Ausführungsbeispiel eine Dicke von 1 mm hat und aus einer Kunststoffmatrix mit eingelagerten Salzen besteht (Polymer-Elektrolyt). Eine randseitige Abdichtung 24 dichtet die Ionenleitschicht 22 zur Elementaußenseite hin ab. Durch sie sind auch in üblicher Weise die mit den Leitschichten 14, 18 verbundenen Kontakte 26, 28 nach außen geführt.

Die folgenden Beispiele veranschaulichen anhand der Beschichtung von Probe-Glasscheiben nach einem bekannten Verfahren und nach Verfahren gemäß der vorliegenden Erfindung, wie Blindladung und Konditionierungszeit bei Anwesenheit von Kohlenwasserstoffen in der Beschichtungsatmosphäre reduziert werden.

### Beispiele 1 - 4

Mit Indium-Zinnoxid (ITO) als Leitschicht mit einem Flächenwiderstand von 10 Ω versehene Glasscheiben der Abmessung 10 · 10 cm² und der Dicke 2 mm wurden in einer DC-Magnetron-Kathodenzerstäubungsanlage mit WOₓ in einer Dicke entsprechend Spalte 2 der Tabelle 1 beschichtet. Die jeweilige Zusammensetzung der Beschichtungsatmosphäre ergibt sich aus den Spalten 3 - 7. Die Angabe "Teile" meint dabei relative Volumenanteile. Die Blindladung wurde im Anschluß an die Schichtherstellung dadurch bestimmt, daß die beschichtete Scheibe in einen Flüssigelektrolyten (Polypropylencarbonat mit Li⁺-Salz) getaucht und einem Lade-/Entladezyklus unterworfen wurde, wobei sich die Blindladung als auf eine Einheitsfläche bezogene Differenz der jeweils geflossenen Ladung bestimmt.

Die Konditionierungszeit wurde an kompletten elektrochromen Elementen des Aufbaus Glas/ITO-Leitschicht/ WOₓ-Elektrode/ Polymer-Elektrolyt/ Ce-Ti-Oxid-Gegenelektrode/ ITO-Leitschicht/ Glas bestimmt.

**Tabelle 1**

| Bsp. Nr. | Dicke [nm] | Relativer Volumenanteil Ar | Relativer Volumenanteil O₂ | Relativer Volumenanteil KW | KW | Gesamtdruck [10⁻² mbar] | Blindladung [mC/cm²] | Kond.-zeit [h] |
|---|---|---|---|---|---|---|---|---|
| 1 | 255 | 4 | 3 | -- | -- | 1,4 | 10,7 | 60 |
| 2 | 260 | 2 | 2 | 1 | Methan | 2,5 | 3,2 | 20 |
| 3 | 255 | 2 | 2 | 2 | Methan | 3,3 | -0,3 | 1 |
| 4 | 270 | 2 | 2 | 2 | Äthan | 3,8 | 0.8 | 4 |

Es wird deutlich erkennbar, daß die Blindladung und damit die Konditionierungszeit durch den erfindungsgemäßen Zusatz eines Kohlenwasserstoffgases deutlich reduziert wird. Der Beschichtungsprozeß verlief vergleichsweise stabil. Störende Kontaminationen der Beschichtungsanlage wurden nicht beobachtet.

Weitere, hier nicht dargestellte Versuche zeigten eine reduzierte Blindladung und insgesamt verbesserte Schichteigenschaften auch bei lonenspeicherschichten wie Cer-Titan-Oxid oder Titan-Vanadium-Oxid.

Es versteht sich, daß die Erfindung auch auf andere als die beispielhaft dargestellten elektrochromen Elemente anwendbar ist. So können insbesondere andere Materialien als ITO, z.B. mit Fluor oder Antimon dotiertes SnO₂, für die Leitschichten eingesetzt werden. Auch ist es möglich, andere Elektrolyten anstelle des vorzugsweise eingesetzten Polymerelektrolyten entsprechend WO 95 / 31 746 A1 zu verwenden. Zwar zeigen sich die Vorteile der Erfindung vor allem bei hermetisch versiegelten elektrochromen Elementen mit begrenzter Menge an Ladungsträgern. Sie ist jedoch ebenfalls mit Vorteil einsetzbar bei elektrochromen Elementen, die vor dem Zusammenbau mit Ladungsträgern gesättigt oder gar übersättigt werden.

## Patentansprüche

1. Verfahren zum Herstellen einer elektrochromen Schicht auf einem Substrat durch Kathodenzerstäubung eines Targets in einer ein Edelgas, insbesondere Argon, und Wasserstoffionen enthaltenden Beschichtungsatmosphäre, **dadurch gekennzeichnet, daß** der Beschichtungsatmosphäre mindestens ein gasförmiger Kohlenwasserstoff zugesetzt wird.

2. Verfahren nach Anspruch 1, **dadurch gekennzeichnet, daß** der Beschichtungsatmosphäre mindestens ein gasförmiger gesättigter Kohlenwasserstoff zugesetzt wird.

3. Verfahren nach Anspruch 2, **dadurch gekennzeichnet, daß** als Kohlenwasserstoff Methan verwendet wird.

4. Verfahren nach Anspruch 2, **dadurch gekennzeichnet, daß** als Kohlenwasserstoff Ethan, Propan oder Butan verwendet wird.

5. Verfahren nach einem der Ansprüche 1 bis 4, **dadurch gekennzeichnet, daß** der Beschichtungsatmosphäre außerdem Sauerstoff zugesetzt wird.

6. Verfahren nach Anspruch 5, **dadurch gekennzeichnet, daß** das Volumenverhältnis von zugesetztem Kohlenwasserstoff zu zugesetztem Sauerstoff im Bereich von 3 : 1 bis 1 : 3, insbesondere etwa 1 : 1, liegt.

7. Verfahren nach Anspruch 5 oder 6, **dadurch gekennzeichnet, daß** das Volumenverhältnis von Edelgas, insbesondere Argon, zu Sauerstoff im Bereich von 3 : 1 bis 1 : 3, insbesondere etwa 1:1, liegt.

8. Verfahren nach einem der Ansprüche 1 bis 7, **dadurch gekennzeichnet, daß** mit einem Gesamtdruck der Beschichtungsatmosphäre von 0,3 ^{·} 10⁻² mbar bis 10⁻¹ mbar, insbesondere von 1^{·}10⁻² mbar bis 4^{·}10⁻² mbar, gearbeitet wird.

9. Verfahren nach einem der Ansprüche 1 bis 8, **dadurch gekennzeichnet, daß** ein aus Wolfram oder einer Wolframlegierung bestehendes Target eingesetzt wird.

10. Verfahren nach einem der Ansprüche 1 bis 9, **dadurch gekennzeichnet, daß** ein Molybdän, Titan, Cer, Vanadium und/oder Zirkon enthaltendes Target verwendet wird.

11. Verfahren nach einem der Ansprüche 1 bis 10, **dadurch gekennzeichnet, daß** die elektrochrome Schicht (16, 20) in einer Dicke im Bereich von 50 nm bis 500 nm aufgebracht wird.

12. Elektrochromes Element mit mindestens einer elektrochromen Schicht (16, 20), die nach einem Verfahren gemäß einem der vorangehenden Ansprüche hergestellt wurde.

13. Elektrochromes Element nach Anspruch 12, **dadurch gekennzeichnet, daß** als Ladungsträger Li⁺-Ionen eingesetzt werden.

## Claims

1. Process for producing an electrochromic layer on a substrate by cathode sputtering of a target in a coating atmosphere containing a noble gas, in particular argon, and hydrogen ions, **characterized in that** at least one gaseous hydrocarbon is added to the coating atmosphere.

2. Process according to claim 1, **characterized in that** at least one gaseous saturated hydrocarbon is added to the coating atmosphere.

3. Process according to claim 2, **characterized in that** methane is used as hydrocarbon.

4. Process according to claim 2, **characterized in that** ethane, propane or butane is used as hydrocarbon.

5. Process according to one of claims 1 to 4, **characterized in that** oxygen is additionally added to the coating atmosphere.

6. Process according to claim 5, **characterized in that** the volume ratio of added hydrocarbon to added oxygen is in the range 3 : 1 to 1 : 3, in particular approximately 1:1.

7. Process according to claim 5 or 6, **characterized in that** the volume ratio of noble gas, in particular argon, to oxygen is in the range of 3 : 1 to 1 : 3, in particular approximately 1:1.

8. Process according to one of claims 1 to 7, **characterized in that** coating takes place at a total pressure of the coating atmosphere of 0.3 · 10⁻² mbar to 10⁻¹ mbar, in particular of 1 · 10⁻² mbar to 4 · 10⁻² mbar.

9. Process according to one of claims 1 to 8, **characterized in that** a target consisting of tungsten or of a tungsten alloy is used.

10. Process according to one of claims 1 to 9, **characterized in that** a target containing molybdenum, titanium, cerium, vanadium and/or zirconium is used.

11. Process according to one of claims 1 to 10, **characterized in that** the electrochromic layer (16, 20) is applied with a thickness in the range of 50 nm to 500 nm.

12. Electrochromic element with at least one electrochromic layer (16, 20) which has been produced according to a process according to one of the foregoing claims.

13. Electrochromic element according to claim 12, **characterized in that** Li⁺ ions are used as charge carriers.

## Revendications

1. Procédé de réalisation d'une couche électrochrome sur un substrat par pulvérisation cathodique d'une cible, dans une atmosphère d'application d'un revêtement, contenant un gaz noble, en particulier de l'argon, et des ions hydrogène, **caractérisé en ce qu'**on ajoute au moins un hydrocarbure gazeux à l'atmosphère de revêtement.

2. Procédé selon la revendication 1, **caractérisé en ce qu'**on ajoute au moins un hydrocarbure gazeux saturé à l'atmosphère de revêtement.

3. Procédé selon la revendication 1, **caractérisé en ce qu'**on utilise du méthane comme hydrocarbure.

4. Procédé selon la revendication 2, **caractérisé en ce qu'**on utilise de l'éthane, du propane ou du butane comme hydrocarbure.

5. Procédé selon l'une des revendications 1 à 4, **caractérisé en ce qu'**on ajoute en outre de l'oxygène à l'atmosphère de revêtement.

6. Procédé selon la revendication 5, **caractérisé en ce que** le rapport en volume de l'hydrocarbure ajouté et de l'oxygène ajouté se situe entre 3:1 et 1:3, en particulier à environ 1:1.

7. Procédé selon la revendication 5 ou 6, **caractérisé en ce que** le rapport en volume du gaz noble, en particulier de l'argon, à l'oxygène, se situe entre 3:1 et 1:3, en particulier à environ 1:1.

8. Procédé selon l'une des revendications 1 à 7, **caractérisé en ce qu'**on travaille avec une pression totale de l'atmosphère de revêtement de 0,3.10⁻²mbar à 10⁻¹ mbar, en particulier 1.10⁻² mbars à 4.10⁻² mbars.

9. Procédé selon l'une des revendications 1 à 8, **caractérisé en ce qu'**on utilise une cible constituée de tungstène ou d'un alliage de tungstène.

10. Procédé selon l'une des revendications 1 à 9, **caractérisé en ce qu'**on utilise une cible contenant du molybdène, du titane, du cérium, du vanadium et/ou du zirconium.

11. Procédé selon l'une des revendications 1 à 10, **caractérisé en ce qu'**on applique la couche électrochrome (16, 20) sur une épaisseur comprise entre 5 nm et 500 nm.

12. Elément électrochrome présentant au moins une couche électrochrome (16, 20) qui a été réalisée suivant un procédé selon l'une des revendications précédentes.

13. Elément électrochrome selon la revendication 12, **caractérisé en ce qu'**on utilise des ions Li⁺ comme support de charge.
